(19)

Europäisches
Patentamt
European
Patent Office
Office européen
des brevets

(11) **EP 2 254 940 B1**

(12) **EUROPEAN PATENT SPECIFICATION**

(45) Date of publication and mention
of the grant of the patent:
**25.06.2014 Bulletin 2014/26**

(51) Int Cl.:
*C08K 3/04* *(2006.01)*    *H01L 21/48* *(2006.01)*

(21) Application number: **09722883.7**

(22) Date of filing: **17.03.2009**

(86) International application number:
**PCT/EP2009/053129**

(87) International publication number:
**WO 2009/115512 (24.09.2009 Gazette 2009/39)**

(54) **HEATSINKS OF THERMALLY CONDUCTIVE PLASTIC MATERIALS**

WÄRMESENKEN VON WÄRMELEITENDEN KUNSTSTOFFMATERIALIEN

DISSIPATEURS THERMIQUES DE MATÉRIAUX PLASTIQUES CONDUCTEURS THERMIQUES

(84) Designated Contracting States:
**AT BE BG CH CY CZ DE DK EE ES FI FR GB GR
HR HU IE IS IT LI LT LU LV MC MK MT NL NO PL
PT RO SE SI SK TR**

(30) Priority: **20.03.2008 EP 08005318**

(43) Date of publication of application:
**01.12.2010 Bulletin 2010/48**

(73) Proprietor: **DSM IP Assets B.V.
6411 TE Heerlen (NL)**

(72) Inventors:
• **JANSSEN, Robert Hendrik Catharina
NL-6191 PC Beek (NL)**
• **VEHMENDAHL VAN, Franciscus
NL-6135 HS Sittard (NL)**

(74) Representative: **van der Ploeg, Antonius
Franciscus M.J.
DSM Intellectual Property
P.O. Box 4
6100 AA Echt (NL)**

(56) References cited:
**WO-A-02/085339**

• **DATABASE WPI Thomson Scientific, London,
GB; AN 2008-E11404 XP002502825 & JP 2007
291267 A (TEIJIN LTD) 8 November 2007
(2007-11-08)**
• **DATABASE WPI Week 200353 Thomson
Scientific, London, GB; AN 2003-561721
XP002502826 & JP 2003 037227 A (NIPPON
LEAKLESS KOGYO KK) 7 February 2003
(2003-02-07)**
• **DATABASE WPI Week 200713 Thomson
Scientific, London, GB; AN 2007-132275
XP002502827 & JP 2007 002231 A (TECHNO
POLYMER CO LTD) 11 January 2007 (2007-01-11)**

**Description**

The invention relates to a heatsink for an electrical or electronic device (denoted herein as E&E device), to E&E devices comprising a heat source and a heatsink as well as to processes for producing the heatsink.

For a heatsink to be effective in dissipating heat from a heat source in an E&E device, the heat source and the heatsink are generally assembled in heat conductive communication with each other. This communication can be either by direct contact or via an interposed isolator, for example via a material layer which material itself is a thermal conductor meanwhile being an electrical isolator.

Heatsinks are used nowadays in many electrical or electronic applications (E&E applications) and can be made from different materials. Whereas traditionally heatsinks were made of metal, nowadays also thermally conductive plastic materials have found their way in the E&E industry and use for construction of the heatsink. Many of these materials are electrically non-conductive and do not need a separate isolator.

In the E&E industry, with the trend to miniaturization and increasing use of more intense heat sources, there is a continuous need for better performing solutions in different aspects. Efficiency in heat dissipation, weight, size, safety, environmental aspects, production reproducibility, automation and flexibility, all play a role.

With the introduction of high current, high output LED lighting, the efficiency in heat dissipation has become even more important. Furthermore, in the event that a LED fails open, the ballast for the power supply may generate a high "strike" voltage. In these applications, metal heatsinks showing a high thermal conductivity, are used. These generally are affixed to the heat source of the LED lighting with a interposed isolator, as mentioned above, for which typically ceramics, plastics, and other materials having a high dielectric strength are used.

Although thermally conductive plastic materials generally combine the properties of thermal conductivity and electrical insulation, they normally suffer in at least one of them. For example, with boron nitride as conductive filler, one can make electrically non-conductive materials, but the thermal conductive properties are limited, so one needs very high loads, whereas for example with aluminum flakes as the thermally conductive filler, the materials become electrically conductive, but at the same time the thermal conductive properties still remain limited. Furthermore, other properties are affected by the type of heat conductive fillers that are used, for example high loads of thermally conductive electrically insulating filler for attaining sufficiently high thermal conductivity resulting in brittle products.

Apart from that, heatsinks are often positioned in close vicinity of electrical leads and wires, which can become very hot as well. For this reason the material from which the heatsink is made should have such flame retarding properties as to prevent ignition by glow wires. With metal this is not a problem, but with plastic materials it can be. To overcome this problem, one might have to add a flame retardant, meanwhile increasing the filler load and thereby reducing the mechanical properties. On the other hand replacing part of the thermally conductive filler by flame retardant would reduce the thermal conductivity of the material.

The aim of the invention is to provide heatsinks made of plastic materials with improved properties in one or more these aspects.

In one embodiment of the invention the heatsink comprises a plastic body made of a thermally conductive plastic material comprising at least 20 wt.% of an expanded graphite, wherein the weight percentage (wt.%) is relative to the total weight of the thermally conductive plastic material.

The heatsinks with a plastic body made of a thermally conductive plastic material comprising at least 20 wt.% expanded graphite showed a substantial improvement in flame retardancy as demonstrated by a higher glow wire flammability index (GWFI).

This improvement in GWFI is already observed without the addition of flame retardant, or need to increase the amount thereof, thus also contributing to retention or even improvement of the mechanical properties compared to other solutions to increase the flame retardancy.

The amount of expanded graphite may be reduced or eventually left out completely provided the in-plane thermal conductivity $\Lambda_{//}$ of the plastic material from which the heatsink is made is at least 7.5 W/m.K. Such a heatsink already showed a noticeably improved GWFI. Therefore, in a second embodiment of the invention the heatsink comprises a plastic body made of a thermally conductive plastic material having an in-plane thermal conductivity $\Lambda_{//}$ of at least 7.5 W/m.K.

In the context of the present invention, it is understood that the thermal conductivity of a plastic composition is a material property, which can be orientation dependent and which also depends on the processing history of the composition. It is realized that for determining the thermal conductivity of a plastic composition, that material has to be shaped into a shape suitable for performing thermal conductivity measurements. Depending on the composition of the plastic composition, the type of shape used for the measurements, the shaping process as well as the conditions applied in the shaping process, the plastic composition may show an isotropic thermal conductivity or an anisotropic. In case the plastic composition is shaped into a flat rectangular shape, the orientation dependent thermal conductivity can generally be described with three parameters: $\Lambda_{\perp}$, $\Lambda_{//}$ and $\Delta_{\pm}$. Herein is:

$\Lambda_\perp$ = the through-plane thermal conductivity,

$\Lambda_{//}$ = the in-plane thermal conductivity in the direction of maximum in-plane thermal conductivity, also indicated herein as parallel or longitudinal thermal conductivity and

$\Lambda_\pm$ = the in-plane thermal conductivity in the direction of minimum in-plane thermal conductivity.

The maximum in-plane thermal conductivity $\Lambda_{//}$ is generally parallel to the direction of the flow of the material. The orientationally averaged thermal conductivity ($\Lambda_{oa}$) is herein defined by the three parameters as follows: $\Lambda_{oa}$ = 1/3 $\cdot$ ($\Lambda_\perp$ + $\Lambda_{//}$ + $\Lambda_\pm$).

The values for the in-plane thermal conductivity $\Lambda_{//}$ mentioned in the present invention refer to $\Lambda$ values measured on injection moulded plaques in parallel to the flow direction with the method described further below in the experimental part.

Depending on the amount of expanded graphite and eventually depending on the type and amount of other thermally conductive components, the thermally conductive plastic material from which the heatsink according to the invention is made, can be either electrically conductive or electrically non-conductive.

In particular cases, depending on the specific E&E device and application, it might be necessary to have a heatsink which is electrically better isolated, whereas in other situations it might be particularly preferred to have a heatsink with further enhanced thermal conductivity properties.

This can be achieved by the following embodiments of the present invention. In the first of these embodiments, the heatsink comprises a plastic body consisting of a thermally conductive plastic material and a coating layer consisting of an electrically insulating plastic material covering at least part of the surface of the plastic body. With the said coating layer the electrical insulating properties of the heatsink are improved.

Advantageously, such a coating layer is applied on a heatsink made of a plastic material that is both thermally and electrically conductive. Preferably the electrically insulating coating layer is applied on a surface area positioned at an outer part of the plastic body, thereby contributing to the safety of the heatsink, for example by preventing short circuitry e.g. in case of external contact by persons and/or tools.

The electrically insulating coating layer may have a thickness varying over a wide range. The preferred thickness can be freely chosen, for example in relation to the function of the heatsink, the material used for the plastic body and the specific requirements for the application. The optimum thickness can be determined by the skilled person by standard testing. Preferably, the coating layer has a thickness such that the heatsink has at a position where the coating layer is applied, an electrical breakdown strength of at least 1 kV, more preferably at least 2 kV, 4 kV or even 6 kV, still more preferably at least 9 kV.

In the second embodiment, the heatsink comprises of a plastic body consisting of a thermally conductive plastic material and a coating layer covering at least part of the plastic body consisting of a metal. The metal coating layer enhances the overall thermal conductivity of the heatsink.

Preferably the metal coating layer is applied on a surface area positioned at an inner part of the plastic body, thereby not detracting from the safety of the heatsink, for example by not inducing short circuitry e.g. in case of external contact by persons and/or tools.

The heatsink according to the invention can be produced by standard molding processes, such as injection molding, using a thermally conductive plastic molding material and optionally subsequently applying a layer of a coating material. The molding material can be either electrically conductive or electrically insulating, whereas the coating material can consist respectively of an electrically insulating plastic material or a metal. The heatsink provides a high thermal conductivity at the side of the electrically conductive plastic material or the metal, and provides for electrical insulation at the side of the electrically insulating plastic material, being either the coating or the plastic body, respectively. In combination with the easy processing of the materials used, it allows for reproducibility, automation and flexibility in production and further miniaturization, weight saving and use of more intense heat sources. Meanwhile due to the increase in GWFI, without the need to use additional flame retardants such as halogen containing flame retardants, they also contribute to enhanced safety and environmental aspects.

The coatings can be applied by conventional coating techniques. For applying the electrically insolating plastic material one might use for example solvent borne coatings or powder coatings, whereas metal sputtering techniques may be applied for applying the metal coating. In a preferred embodiment, the heatsink comprises a plastic body consisting of an electrically conductive plastic material, which is coated with a powder coating using electrostatic powder spraying techniques.

In particular the heatsinks made with the plastic body made of the thermally conductive plastic material comprising a substantial amount of expanded graphite showed to be very suited to apply a powder coating on. The material comprising at least 20 wt.% expanded graphite can be coated with a powder coating without prior treatment of the molded part.

If the electrical conductivity of the plastic body is too low, for example for applying a powder coating, this may be enhanced applying a metal coating layer at an opposite surface of the heatsink.

The electrical conductivity of the plastic material, respectively the electrical insulating properties of the plastic material and the heatsink can be measured by standard techniques used in the E&E industry.

The plastic material in the heatsink according to the invention may have a thermal conductivity varying over large range, provided the in-plane thermal conductivity $\Lambda_{//}$ is at least 7.5 W/m.K.

Suitably, the in-plane thermal conductivity $\Lambda_{//}$ is 25 W/m.K or higher, as can be realized with high loadings of expanded graphite. A higher in-plane thermal conductivity $\Lambda_{//}$ contributes to a better heat dissipation of the heat from the heat source, as well as higher GWFI values. Preferably the in-plane thermal conductivity $\Lambda_{//}$ is in the range of 10-20 W/m.K, more preferably 12-15 W/m.K. With this preferred range an optimum balance in heat conductivity, molding properties, mechanical properties and GWFI values is obtained.

The electrical conductivity may vary over a large range as well. No specific limiting boundaries need to be given. If the material has a relatively high electrical conductivity, this may be compensated with an electrically insulating coating layer. The electrically insulating properties of the heatsink may be controlled by varying the thickness of the coating layer in combination with the insulating properties of the plastic body.

For making the heatsink according to the invention a thermally conductive plastic composition is used. This composition may be any composition having sufficient thermal conductivity and being suitable for making plastic parts. Typically such a composition comprises a polymeric material and a thermally conductive component, such as thermally conductive fillers and thermally conductive fibers, dispersed in the polymer. These thermally conductive filler and fibers may also be electrically conductive, thereby imparting also electrically conductive properties to the thermally plastic material. Next to these, the plastic composition may comprise other components, which components may comprise any auxiliary additive used in conventional plastic compositions for making moulded plastic parts.

The polymer may be any polymer that is suitable for making thermal conductive plastic compositions may be used, and include both include both thermoplastic polymers and thermoset polymers. Suitably, the polymer is able to work at elevated temperatures without significant softening or degradation of the plastic and can comply with the mechanical and thermal requirements for the heatsink, which will depend on the specific application and design of the heatsink. The compliance with such requirements can be determined by the person skilled in the art of making moulded plastic parts by systematic research and routine testing.

Preferably, the polymer comprises a thermoplastic polymer. The thermoplastic polymer can be an amorphous, a semi-crystalline or a liquid crystalline polymer, an elastomer, or a combination thereof. Liquid crystal polymers are preferred due to their highly crystalline nature and ability to provide a good matrix for the filler material.

Preferably, the thermoplastic polymer is a chosen from the group consisting of polyesters, polyamides, polyphenylene sulphides, polyphenylene oxides, polysulfones, polyarylates, polyimides, polyethertherketones, and polyetherimides, and mixtures and copolymers thereof.

The thermoplastic polymer may comprise a semi-crystalline polyamide, which have the advantage of having good thermal properties and mould filling characteristics.

More preferably, the thermoplastic polymer comprises a semi-crystalline polyamide with a melting point of at least 200 °C, more preferably at least 220 °C, 240 °C, or even 260 °C and most preferably at least 280 °C. Semi-crystalline polyamides with a higher melting point have the advantage that the thermal properties are further improved. With the term melting point is herein understood the temperature measured by DSC with a heating rate of 5 °C falling in the melting range and showing the highest melting rate.

Preferably, the plastic composition has a heat distortion temperature, measured according to ISO 75-2, nominal 0.45 MPa stress applied (HDT-B), of at least 180°C, more preferably at least 200 °C, 220°C, 240°C, 260°C, or even at least 280°C. The advantage of the plastic composition having a higher HDT is that the heatsink has a better retention of mechanical properties at elevated temperature and the heatsink can be used for applications more demanding in mechanical and thermal performance.

As thermally conductive component in the thermally conductive plastic composition for the heatsink in principle any material that can be dispersed in the polymer and that improves the thermal conductivity of the plastic composition can be used. Suitable thermally conductive components include, for example, aluminium, alumina, copper, magnesium, brass, carbon, silicon nitride, aluminium nitride, boron nitride, zinc oxide, glass, mica, graphite, ceramic fibre and the like. Mixtures of such thermally conductive components are also very suitable, in particular mixtures comprising expanded graphite.

The thermally conductive component may be in the form of granular powder, particles, whiskers, short fibres, or any other suitable form. The particles can have a variety of structures. For example, the particles can have flake, plate, rice, strand, hexagonal, or spherical-like shapes.

The thermally conductive component suitably is a thermally conductive filler or a thermally conductive fibrous material, or a combination thereof. A filler is herein understood to be a material consisting of particles with an aspect ratio of less than 10:1. Suitably, the filler material has an aspect ratio of about 5:1 or less. For example, boron nitride granular particles having an aspect ratio of about 4:1 can be used. A fibre is herein understood to be a material consisting of particles with an aspect ratio of at least 10:1. More preferably the thermally conductive fibres consisting of particles with an aspect ratio of at least 15:1, more preferably at least 25:1.

Preferably, both low aspect and high aspect ratio thermally conductive components, i.e. both thermally conductive fillers and fibres, are comprised by the plastic composition, as described in McCullough, U.S. patents 6,251,978 and 6,048,919, the disclosure of which are hereby incorporated by reference.

For the thermally conductive fibres in the thermally conductive plastic composition any fibres that improve the thermal conductivity of the plastic composition can be used. Suitably, the thermally conductive fibres comprise glass fibres, metal fibres and / or carbon fibres. Suitable carbon-fibres, also known as graphite fibres, include PITCH-based carbon fibre and PAN-based carbon fibres. For example, PITCH-based carbon fibre having an aspect ratio of about 50:1 can be used. PITCH-based carbon fibres contribute significantly to the heat conductivity. On the other hand PAN-based carbon fibres have a larger contribution to the mechanical strength.

The choice of thermally conductive component will depend on the further requirements for the heatsink and the amounts that have to be used depend on the type of thermally conductive component and the level of heat conductivity required.

The plastic composition in the heatsink according to the invention suitably comprises 30-80 wt% of the thermoplastic polymer and 20-70 wt% of the thermally conductive component, preferably 40-75 wt % of the thermoplastic polymer and 25-60 wt % of the thermally conductive component, wherein the wt% are relative to the total weight of the plastic composition. It is noted that the amount of 20 wt.% might be sufficient for one type of thermally conductive component to attain an in- plane thermal conductivity of at least 7.5 W/m.K, such as for specific grades of graphite, whereas for others, such as pitch carbon fibres, boron nitride and in particular glass fibres, much higher wt.% are needed. The amounts necessary to attain the required levels can be determined by the person skilled in the art of making thermally conductive polymer compositions by routine experiments.

In a preferred embodiment of the invention, the thermally conductive component comprises graphite, more particularly an expanded graphite. Whereas many other thermally conductive components suffer from one or more of the following properties in that they are either brittle, expensive, hard, abrasive, and/or low in thermal conductivity, graphite combines a high thermal conductivity with limited brittleness, and hardness, abrasiveness if any, and is relatively cheap.

Preferably, electrically conductive plastic material is a thermoplastic material comprising a thermoplastic polymer and a graphite filler, more preferably the composition comprises a thermally conductive component consisting for at least 50 wt.% of graphite, even more preferably at least 75 wt.% of graphite, relative to the total weight of the thermally conductive component.

The advantage of expanded graphite as the thermally conductive component in the plastic composition from which the heatsink is made is that it imparts a high thermal conductivity already at a relatively low weight percentage, meanwhile significantly improving the GWFI properties.

This effect of further increased GWFI is already obtained when part of the thermally conductive component consists of expanded graphite, and becomes more significant when the thermal conductivity reaches higher levels, such as values above 7.5 W/m.K, whereas the effect becomes even higher when the relative content (wt.% relative to the total weight of thermally conductive component), as well as the absolute content of expanded graphite wt.% (relative to the total weight of thermally conductive plastic composition) is higher. Preferably, the relative content of expanded graphite is at least 25 wt%, or better at least 50 wt%, or even at least 75 wt.%, i.e. relative to the total weight of thermally conductive component. Also preferably, the absolute content is at least 15 wt%, or better at least 20 wt%, or even better at least 25 wt.%, and most preferably at least 30 wt.%, i.e. relative to the total weight of thermally conductive plastic composition.

The plastic composition, from which the heatsink according to the invention is made, may further comprise, next to the thermoplastic polymer and the thermally conductive component, other components, denoted herein as additives. As additives, the thermally conductive plastic material may comprise any auxiliary additive, known to a person skilled in the art that are customarily used in polymer compositions. Preferably, these additives should not detract, or not in a significant extent, from the invention. Whether an additive is suitable for use in the heatsink according to the invention can be determined by the person skilled in the art of making polymer compositions for heatsinks by routine experiments and simple tests. These additives include, in particular, non-conductive fillers and non-conductive reinforcing agents, and other additives such as pigments, dispersing aids, processing aids, for example lubricants and mould release agents, impact modifiers, plasticizers, crystallization accelerating agents, nucleating agents, UV stabilizers, antioxidants and heat stabilizers, and the like. In particular, the thermally conductive plastic composition contains a non-conductive inorganic filler and/or non-conductive reinforcing agent. Suitable for use as a non-conductive inorganic filler or reinforcing agent are all the fillers and reinforcing agents known to a person skilled in the art, and more particular auxiliary fillers, not considered thermally conductive fillers. Suitable non-conductive fillers are, for example asbestos, mica, clay, calcined clay and talcum.

The additives are suitably present, if any, in a total amount of 0-50 wt.%, preferably 0.5-25 wt.%, more preferably 1-12.5 wt.% relative to the total weight of the plastic composition.

The non-conductive fillers and fibres are preferably present, if any, in a total amount of 0-40 wt.%, preferably 0.5-20 wt.%, more preferably 1-10 wt.%, relative to the total weight of the plastic composition, whereas the other additives are preferably present, if any, in a total amount of 0-10 wt.%, preferably 0.25-5wt.%, more preferably 0.5-2.5 wt.%, relative to the total weight of the plastic composition.

In a preferred embodiment, the thermally conductive plastic material in the plastic body of the heatsink consists of 30-80 wt.% of a thermoplastic polymer, 20-70 wt% of the thermally conductive component, and 0-50wt.% additives, wherein the weight percentages (wt.%) are relative to the total weight of the thermally conductive plastic material.

More preferably, for the thermoplastic polymer, the thermally conductive component, and the additives, the preferred components and amounts as described herein further above are chosen.

The insulating coating layer may have been produced from any electrically insulating plastic material, and suitably has been derived from a thermoplastic or thermoset coating composition.

Preferably, the coating layer is a cured powder coating derived from a thermoset powder coating composition.

Suitably, the coating layer consists of a plastic composition comprising a polymeric system, being either a thermoplast polymer or a thermoset polymer, and at least one additive. The additive may be any additive suitable for use in a coating system. Preferably the nature and amount of the additive are such that the coating layer remains electrically non-conductive. Preferably, the additive comprises a pigment, more preferably a black pigment. The advantage of a dark pigment, in particular a black pigment, is that the heat dissipation of the heatsink is further enhanced.

The metal coating layer may consist of any metal that is suitable for being applied on a plastic. Suitably, the metal is cupper or aluminum.

The E &E device according to the invention may be any E&E device comprising a heat source and a heatsink, for example the E&E device is a semiconductor device comprising a semiconductor connected to the heatsink, or a LED device comprising a multiplicity of LEDs on a metal core PCB connected to a heat spreader.

Preferably, the heatsink is a heat spreader acting as a protective housing for the electronic parts of an LED device. The advantage of such an E&E device, wherein heatsink is a protective housing enveloping electronic parts of an LED device, is that the electronic parts are properly shielded from external contacts, protected by short circuitry following from such contacts, and protected from overheating by the LEDs. Meanwhile the LED device has all other advantages of the E&E device and heatsink therein as according to the present invention.

Experimental part.

Materials

Moulding compositions were prepared from polyamide-46 and carbon pitch fiber (CPF), boron nitride (BN) and expanded graphite (EG), respectively, in an extruder using standard melt compounding process. From the compositions test samples with dimensions of 80 x 80 x 1 mm were prepared by injection moulding using an injection moulding machine equipped with a square mould with the proper dimensions and a film gate of 80 mm wide and 1 mm high positioned at one side of the square.

Of the 1 mm thick injection molded plaques the through plane ($\Lambda_\perp$) and in-plane ($\Lambda_{//}$) thermal conductivity and the GWFI was measured.

Measurement of GWFI

The GWFI (Glow wire flammability index) was measured according to IEC 60695-2-12

Measurement of through plane ($\Lambda_\perp$) and in-plane ($\Lambda_{//}$) thermal conductivity

The through plane ($\Lambda_\perp$) and in-plane ($\Lambda_{//}$) thermal conductivity were measured via determination of the thermal diffusivity D, the density (p) and the heat capacity (Cp).

The thermal diffusivity was determined in a direction in-plane and parallel ($D_{//}$) and in-plane and perpendicular ($D_\pm$) to the direction of polymer flow upon mold filling, as well as through plane ($D_\perp$), according to ASTM E1461-01 with Netzsch LFA 447 laserflash equipment. The in-plane thermal diffusivities $D_{//}$ and $D_\pm$ were determined by first cutting small strips or bars with an identical width of about 1 mm wide from the plaques. The length of the bars was in the direction of, respectively perpendicular to, the polymer flow upon mold filling. Several of these bars were stacked with the cut surfaces facing outwards and clamped very tightly together. The thermal diffusivity was measured through the stack from one side of the stack formed by an array of cut surfaces to the other side of the stack with cut surfaces.

The heat capacity (Cp) of the plates was determined by comparison to a reference sample with a known heat capacity (Pyroceram 9606), using the same Netzsch LFA 447 laserflash equipment and employing the procedure described by W. Nunes dos Santos, P. Mummery and A. Wallwork, Polymer Testing 14 (2005), 628-634.

From the thermal diffusivity (D), the density (ρ) and the heat capacity (Cp), the thermal conductivity of the molded plaques was determined in a direction parallel ($\Lambda_{//}$) and perpendicular ($\Lambda_{\pm}$) to the direction of polymer flow upon mold filling, as well as perpendicular to the plane of the plaques ($\Lambda_{\perp}$), according to formula (V):

$$\Lambda_x = D_x * \rho * Cp \qquad\qquad (V)$$

wherein x = //, $\pm$ and $\perp$, respectively.

Test results

The compositions of and test results for the different materials and tests have been have been collected in Table I.

Table 1: Material compositions (wt.%), thermal conductivity data (W/m.K) and GWFI evaluation [a)] for Comparative Experiment A-D and Examples I-XII.

|  | PA46 | CPF | EG | BN | $\Lambda_{\perp}$ | $\Lambda_{//}$ | GWFI 650 | GWFI 960 |
|---|---|---|---|---|---|---|---|---|
| CE-A | 70 | 30 |  |  | 0.6 | 4.1 | Pass | Fail |
| CE-B | 55 | 45 |  |  | 0.9 | 6.0 | Pass | Fail |
| CE-C | 85 |  | 15 |  | 1.2 | 3.0 | Pass | Fail |
| EX I | 70 |  | 30 |  | 1.6 | 13 | Pass | Pass |
| CE-D | 70 |  |  | 30 | 0.7 | 3.6 | Pass | Fail |
| EX II | 40 |  |  | 60 | 1.5 | 13.5 | Pass | Pass |

Preparation of a heatsink

The material used in Example I was used to mold a heatsink for an LED device, having the shape of a cylindrical cup intended to act as a protective housing for the electronic parts of the LED device. The outer surface of the cup was coated electrostatically with a thermoset polyester powder coating and cured in an oven using standard curing conditions. The cup showed very good heat shealding and heat dissipation properties and electrical insulation.

**Claims**

1. Heatsink for an electrical or electronic device comprising a plastic body made of a thermally conductive plastic material comprising of an expanded graphite in an amount of at least 20 wt.%, relative to the total weight of the thermally conductive plastic material.

2. Heatsink for an electrical or electronic device comprising a plastic body made of a thermally conductive plastic material having an in-plane thermal conductivity $\Lambda_{//}$ of at least 7.5 W/m.K.

3. Heatsink according to claim 1 or 2, comprising a metal coating layer covering at least part of the surface of the plastic body.

4. Heatsink according to claim 1 or 2, comprising a coating layer, consisting of an electrically insulating plastic material, covering at least part of the surface of the plastic body.

5. Heatsink according to claim 4, wherein the thermally conductive plastic material is electrically conductive and the heat sink has an electrical breakdown strength, at a position where the coating layer is applied, of at least 1 kV.

6. Heatsink according to claim 2, wherein the thermally conductive plastic material comprises a mixture of thermally conductive components, comprising an expanded graphite, preferably in an amount of at least 25 wt.% relative to the total amount of thermally conductive components.

7. Heatsink according to any of the above claims, wherein the thermally conductive plastic material consists of 30-80 wt.% of a thermoplastic polymer, 20-70 wt% of a thermally conductive component, and 0-50wt.% of additives, wherein the weight percentages (wt.%) are relative to the total weight of the thermally conductive plastic material.

8. Process for making a heatsink for an electrical or electronic device comprising injection molding of an thermally conductive plastic material thereby forming a thermally conductive plastic body, followed by applying a coating layer on at least part of the plastic body, wherein the thermally conductive plastic material comprises an expanded graphite in an amount of at least 20 wt.%, relative to the total weight of the thermally conductive plastic material and/or having an in-plane thermal conductivity $\Lambda_{//}$ of at least 7.5 W/m.K.

9. Process according to claim 8, wherein the plastic material is electrically conductive and the coating layer consists of an electrically insulating material, or where the plastic material is electrically non-conductive and the coating layer is a metal layer.

10. Process for making an E&E device, comprising assembling a heatsink according to any of claims1-7, or obtainable by a process according to claim 8 or 9, in heat conductive communication with a heat generating device.

11. Electrical or electronic device (E&E device), comprising a heat source and a heatsink according to any of claims 1-7 in heat conductive communication with each other.

12. E&E device according to claim 11, wherein the E&E device is a semiconductor device comprising a semiconductor connected to the heatsink, or a LED device comprising a multiplicity of LEDs on a metal core PCB connected to a heat spreader.

13. E&E device according to claim 11, wherein heatsink is a protective housing enveloping electronic parts of an LED device.

**Patentansprüche**

1. Wärmesenke für eine elektrische oder elektronische Vorrichtung, umfassend einen Kunststoffkörper, der aus einem wärmeleitfähigen Kunststoffmaterial hergestellt ist, das einen expandierten Graphit in einer Menge von mindestens 20 Gew.-%, auf das Gesamtgewicht des wärmeleitfähigen Kunststoffmaterials bezogen, umfasst.

2. Wärmesenke für eine elektrische oder elektronische Vorrichtung, umfassend einen Kunststoffkörper, der aus einem wärmeleitfähigen Kunststoffmaterial hergestellt ist, das eine Wärmeleitfähigkeit in Plattenrichtung L" von mindestens 7,5 W/m.K aufweist.

3. Wärmesenke nach Anspruch 1 oder 2, umfassend eine Metallbeschichtungsschicht, die mindestens einen Teil der Oberfläche des Kunststoffkörpers bedeckt.

4. Wärmesenke nach Anspruch 1 oder 2, umfassend eine Beschichtungsschicht, die aus einem elektrisch isolierenden Kunststoffmaterial besteht, das mindestens einen Teil der Oberfläche des Kunststoffkörpers bedeckt.

5. Wärmesenke nach Anspruch 4, wobei das wärmeleitfähige Kunststoffmaterial elektrisch leitfähig ist und die Wärmesenke eine elektrische Durchschlagstärke von mindestens 1 kV an einer Position aufweist, an der die Beschichtungsschicht aufgebracht wird.

6. Wärmesenke nach Anspruch 2, wobei das wärmeleitfähige Kunststoffmaterial eine Mischung von wärmeleitfähigen Komponenten umfasst, die einen expandierten Graphit bevorzugt in einer Menge von mindestens 25 Gew.-%, auf die Gesamtmenge von wärmeleitfähigen Komponenten bezogen, umfassen.

7. Wärmesenke nach einem der obigen Ansprüche, wobei das wärmeleitfähige Kunststoffmaterial aus 30 - 80 Gew.-% eines thermoplastischen Polymers, 20 - 70 Gew.-% einer wärmeleitfähigen Komponente und 0 - 50 Gew.-% Zusatzmitteln besteht, wobei die Gewichtsprozentsätze (Gew.-%) auf das Gesamtgewicht des wärmeleitfähigen Kunststoffmaterials bezogen sind.

8. Verfahren zur Herstellung einer Wärmesenke für eine elektrische oder elektronische Vorrichtung, umfassend das Spritzgießen eines wärmeleitfähigen Kunststoffmaterials, wodurch ein wärmeleitfähiger Kunststoffkörper gebildet wird, gefolgt vom Aufbringen einer Beschichtungsschicht auf mindestens einen Teil des Kunststoffkörpers, wobei das wärmeleitfähige Kunststoffmaterial einen expandierten Graphit in einer Menge von mindestens 20 Gew.-%, auf das Gesamtgewicht des wärmeleitfähigen Kunststoffmaterials bezogen, umfasst und/oder eine Wärmeleitfähigkeit in Plattenrichtung L" von mindestens 7,5 W/m.K aufweist.

9. Verfahren nach Anspruch 8, wobei das Kunststoffmaterial elektrisch leitfähig ist und die Beschichtungsschicht aus einem elektrisch isolierenden Material besteht oder wobei das Kunststoffmaterial elektrisch nichtleitfähig ist und die Beschichtungsschicht eine Metallschicht ist.

10. Verfahren zur Herstellung einer E&E-Vorrichtung, umfassend das Zusammenbauen einer Wärmesenke nach einem der Ansprüche 1 - 7 oder durch ein Verfahren nach Anspruch 8 oder 9 erhältlich, in wärmeleitfähiger Kommunikation mit einer wärmeerzeugenden Vorrichtung.

11. Elektrische oder elektronische Vorrichtung (E&E-Vorrichtung), umfassend eine Wärmequelle und eine Wärmesenke nach einem der Ansprüche 1 - 7 in wärmeleitfähiger Kommunikation miteinander.

12. E&E-Vorrichtung nach Anspruch 11, wobei die E&E-Vorrichtung eine Halbleitervorrichtung, die einen Halbleiter, der an die Wärmesenke angeschlossen ist, umfasst, oder eine LED-Vorrichtung ist, die eine Vielzahl von LED auf einer mit einem Wärmeverteiler verbundenen Metallkern-Leiterplatte umfasst.

13. E&E-Vorrichtung nach Anspruch 11, wobei die Wärmesenke ein Schutzgehäuse ist, das elektronische Teile einer LED-Vorrichtung umhüllt.

## Revendications

1. Dissipateur thermique pour un dispositif électrique ou électronique comprenant un corps plastique constitué d'un matériau plastique thermiquement conducteur composé d'un graphite expansé dans une quantité d'au moins 20 % en poids, rapporté au poids total du matériau plastique thermiquement conducteur.

2. Dissipateur thermique pour un dispositif électrique ou électronique comprenant un corps plastique constitué d'un matériau plastique thermiquement conducteur ayant une conductivité thermique dans le plan $\Lambda_{//}$ d'au moins 7,5 W/m.K.

3. Dissipateur thermique selon la revendication 1 ou 2, comprenant une couche de revêtement métallique recouvrant au moins une partie de la surface du corps plastique.

4. Dissipateur thermique selon la revendication 1 ou 2, comprenant une couche de revêtement, consistant en un matériau plastique électriquement isolant, recouvrant au moins une partie de la surface du corps plastique.

5. Dissipateur thermique selon la revendication 4, dans lequel le matériau plastique thermiquement conducteur est électriquement conducteur, le dissipateur thermique ayant une résistance au claquage électrique, à une position où la couche de revêtement est appliquée, d'au moins 1 kV.

6. Dissipateur thermique selon la revendication 2, dans lequel le matériau plastique thermiquement conducteur comprend un mélange de composants thermiquement conducteurs, comprenant un graphite expansé, de préférence dans une quantité d'au moins 25 % en poids, rapporté à la quantité totale de composants thermiquement conducteurs.

7. Dissipateur thermique selon l'une quelconque des revendications précédentes, dans lequel le matériau plastique thermiquement conducteur 30-80 % en poids d'un polymère thermoplastique, 20-70 % en poids d'un composant thermiquement conducteur, et 0-50 % en poids d'additifs, les pourcentages pondéraux (% en poids) se rapportant au poids total du matériau plastique thermiquement conducteur.

8. Procédé de fabrication d'un dissipateur thermique pour un dispositif électrique ou électronique comprenant le moulage par injection d'un matériau plastique thermiquement conducteur pour former ainsi un corps plastique thermiquement conducteur, suivi de l'application d'une couche de revêtement sur au moins une partie du corps plastique, le matériau plastique thermiquement conducteur comprenant un graphite expansé dans une quantité d'au moins 20 % en poids, rapporté au poids total du matériau plastique thermiquement conducteur, et/ou ayant une conductivité thermique dans le plan $\Lambda_{//}$ d'au moins 7,5 W/m.K.

9. Procédé selon la revendication 8, dans lequel le matériau plastique est électriquement conducteur et la couche de revêtement consiste en un matériau électriquement isolant, ou dans lequel le matériau plastique est électriquement non-conducteur et la couche de revêtement est une couche métallique.

10. Procédé de fabrication d'un dispositif E&E, comprenant l'assemblage d'un dissipateur thermique selon l'une quelconque des revendications 1 à 7, ou pouvant être obtenu par un procédé selon la revendication 8 ou 9, en communication de conduction thermique avec un dispositif générant de la chaleur.

11. Dispositif électrique ou électronique (dispositif E&E), comprenant une source de chaleur et un dissipateur thermique selon l'une quelconque des revendications 1 à 7 en communication de conduction thermique l'un avec l'autre.

12. Dispositif E&E selon la revendication 11, le dispositif E&E étant un dispositif semi-conducteur comprenant un semi-conducteur relié au dissipateur thermique, ou un dispositif à DEL comprenant une multiplicité de DEL sur une carte de circuit imprimé à coeur métallique reliée à un diffuseur thermique.

13. Dispositif E&E selon la revendication 11, dans lequel le dissipateur thermique est un boîtier protecteur enveloppant des pièces électroniques d'un dispositif à DEL.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6251978 B, McCullough

- US 6048919 A

**Non-patent literature cited in the description**

- **W. NUNES DOS SANTOS ; P. MUMMERY ; A. WALLWORK.** *Polymer Testing,* 2005, vol. 14, 628-634